# EUROPEAN PATENT APPLICATION

(11) **EP 2 819 389 A1**
(43) Date of publication of application: **31.12.2014**
(21) Application number: 13751379.2
(22) Date of filing: 19.02.2013
(51) Int. Cl.: H04N 1/04, F21S 2/00, H04N 1/028

(54) **LIGHT-GUIDE UNIT AND IMAGE SENSOR**

(30) Priority: 22.02.2012 JP 2012035955
(71) Applicant: Mitsubishi Electric Corporation, Tokyo 100-8310 (JP)
(72) Inventor: ABE, Ichihiro, Tokyo 100-8310 (JP); OKAMURA, Koichiro, Tokyo 100-8310 (JP); NOKAMI, Yohei, Tokyo 100-8310 (JP)
(74) Representative: Sajda, Wolf E.
(86) International application number: PCT/JP2013/053924
(87) International publication number: WO 2013/125501

(57) **Abstract**

A light guide unit (20) includes, a first light guide (21) having a column shape that takes a light incident upon one end surface and emits a light from other end surface and from a light emitter on a side surface of the first light guide (21), and a second light guide (22) having a column shape that takes the light emitted from the other end surface of the first light guide (21) then incident upon one end surface of the second light guide (22), and emits the light from a light emitter on a side surface of the second light guide (22), and the one end surface of the second light guide (22) are located close proximity to the other end surface of the first light guide (21). The first light guide (21) includes a first mating member (28A), and the second light guide (22) includes a second mating member (28B) engaging with a first alignment member such that the side surface of the first light guide (21) having the light emitter and the side surface of the second light guide (22) having the light emitter are flush with each other, and the other end surface of the first light guide (21) is located close proximity to the one end surface of the second light guide (22).

## Description

### Technical Field

The present disclosure relates to a light guide unit and an image sensor.

### Background Art

Contact image sensors used for devices such as image scanners employ light guides. The light guides modify a light generated by a light source into the form of a linear light which extends in a primary scan direction on a document positioning surface. Cylindrical shapes are employed to some of the light guides. The cylindrical light guide is arranged to have its longitudinal direction (side surface) located opposite to the primary scan direction on the document positioning surface.

The light emitted from the light source enters into the light guide at an end surface thereof, and then the light is emitted from emitters on the side surface of the light guide. The light emitted from the light guide is modified to an extending light in the primary scan direction to illuminate the document positioning surface.

It is essential to provide a uniform illumination on the document positioning surface in the primary scan direction by implementing emitters in the form of a straight line on the light guide for accurate reading of the document. However, warping deformation in the light guides is likely to occur as the light guides are made of transparent resin materials such as acrylic or polycarbonate, and an extrusion process is used for producing such light guides. Therefore, manufacture of the light guides longer than a certain length had been difficult.

Given that, image sensors including an long-length light guide formed by connecting multiple-divided pieces of light guide, have been introduced (see, for example, Patent Literatures 1 and 2).

### Citation List

### Patent Literature

- Patent Literature 1:: Unexamined Japanese Patent Application Kokai Publication JP-A-2008-147 772
- Patent Literature 2:: International Publication No. WO 2006/049206 A

### Summary of the Invention

### Technical Problem

However, in the image sensor described in Patent Literature 1, a light emitted by the light guide cannot be maintained as a straight line profile when a displacement occurs in a position at which the two light guides are fixed onto the housing. As a result, it is difficult to provide a uniform illumination on the document positioning surface in the primary scan direction.

The present disclosure has been made in view of such problems, and an object of the present disclosure is to provide a light guide unit capable of providing uniform illumination on the document positioning surface in the primary scan direction, and an image sensor, in simple structures.

### Solution to the Problem

To achieve the aforementioned objective, a light guide unit according to the present disclosure includes, a first light guide in a column shape that is adapted to take a light incident upon one end surface of the first light guide, and to emit the light from other end surface thereof and from a light emitter on a side surface thereof bridging between the one end surface and the other end surface,
a second light guide in a column shape that is adapted to take the light emitted from the other end surface of the first light guide and incident upon one end surface of the second light guide, and to emit the light from the light emitter on a side surface thereof bridging between the one end surface and the other end surface of the second light guide, and the one end surface of the second light guide is located close proximity to the other end surface of the first light guide,
a first alignment member formed on the first light guide,
a second alignment member formed on the second light guide, wherein the other end surface of the first light guide and the one end surface of the second light guide are located close proximity to each other, and the side surface having the light emitter on the first light guide and the side surface having the light emitter on the second light guide are flush with each other, such that the first alignment member is engaged with the second alignment member.

### Advantageous Effects of the Invention

According to the present disclosure, the long-length light guide unit capable of producing the uniform illumination on the document positioning surface in the primary scan direction, and the image sensor, in simple structures, are provided.

### Brief Description of the Drawings

- FIG. 1: is a cross-sectional view of a contact image sensor according to Embodiment 1 of the present disclosure;
- FIG. 2A: is an exploded perspective view of an illuminating device according to Embodiment 1 of the present disclosure;
- FIG. 2B: is a perspective view of the illuminating device of FIG. 2A;
- FIG. 2C: is a cross-sectional view of a portion of an optical path within the light guide unit of FIG. 2B, taken along line II-II;
- FIG. 3A: is a front view of an end portion on a first light guide according to Embodiment 1 of the present disclosure;
- FIG. 3B: is a right side view of the end portion on the first light guide according to Embodiment 1 of the present disclosure;
- FIG. 4A: is a left side view of an end portion on a second light guide according to Embodiment 1 of the present disclosure;
- FIG. 4B: is a front view of the end portion on the second light guide according to Embodiment 1 of the present disclosure;
- FIG. 5: is a front view showing the end portion on the first light guide being coupled to an end portion on the second light guide according to Embodiment 1 of the present disclosure;
- FIG. 6: is a perspective view of the illuminating device including spacers attached thereon according to Embodiment 1 of the present disclosure;
- FIG. 7A: is a front view showing an end portion on the first light guide according to Embodiment 2 of the present disclosure;
- FIG. 7B: is a right side view of an end portion on the first light guide according to Embodiment 2 of the present disclosure;
- FIG. 8A: is a left side view of an end portion on the second light guide according to Embodiment 2 of the present disclosure;
- FIG. 8B: is a front view showing an end portion of the second light guide according to Embodiment 2 of the present disclosure;
- FIG. 9: is a front view showing the end portion on the first light guide being coupled to an end portion on the second light guide according to Embodiment 2 of the present disclosure;
- FIG. 10A: is a front view showing an end portion of the first light guide according to Embodiment 3 of the present disclosure;
- FIG. 10B: is a right side view showing the end portion on the first light guide according to Embodiment 3 of the present disclosure;
- FIG. 11A: is a left side view of an end portion on the second light guide according to Embodiment 3 of the present disclosure;
- FIG. 11B: is a front view of an end portion on the second light guide according to Embodiment 3 of the present disclosure;
- FIG. 12: is a front view showing an end portion on the first light guide being coupled to an end portion on the second light guide according to Embodiment 3 of the present disclosure;
- FIG. 13: is a cross-sectional view of the contact image sensor according to Embodiment 3 of the present disclosure;
- FIG. 14: is a perspective view of the illuminating device according to Embodiment 4 of the present disclosure;
- FIG. 15: is a perspective view of the illuminating device according to Embodiment 5 of the present disclosure; and

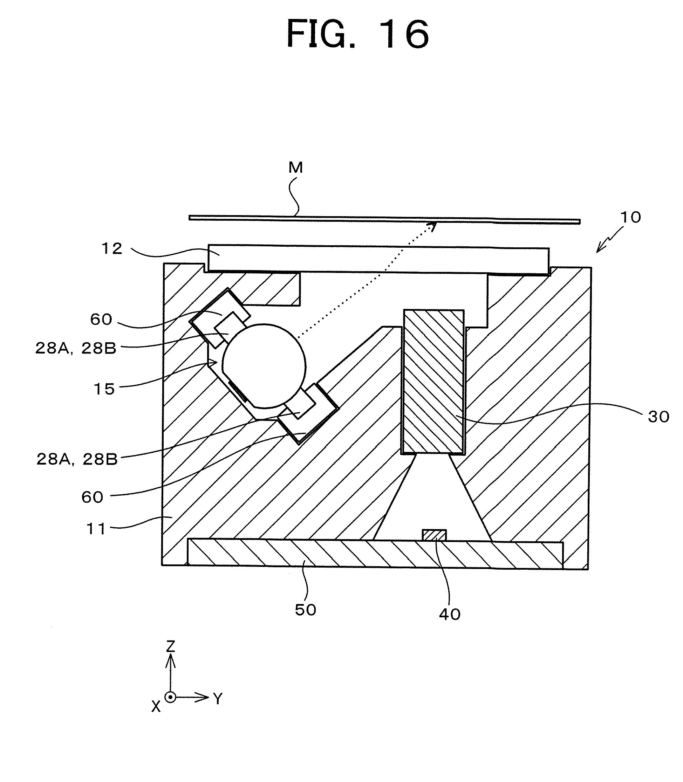

- FIG. 16: is a cross-sectional view of the contact image sensor according to other embodiments of the present disclosure.

### Description of Embodiments

Hereinafter, embodiments of the present disclosure is described with reference to the figures attached herein.

### Embodiment 1

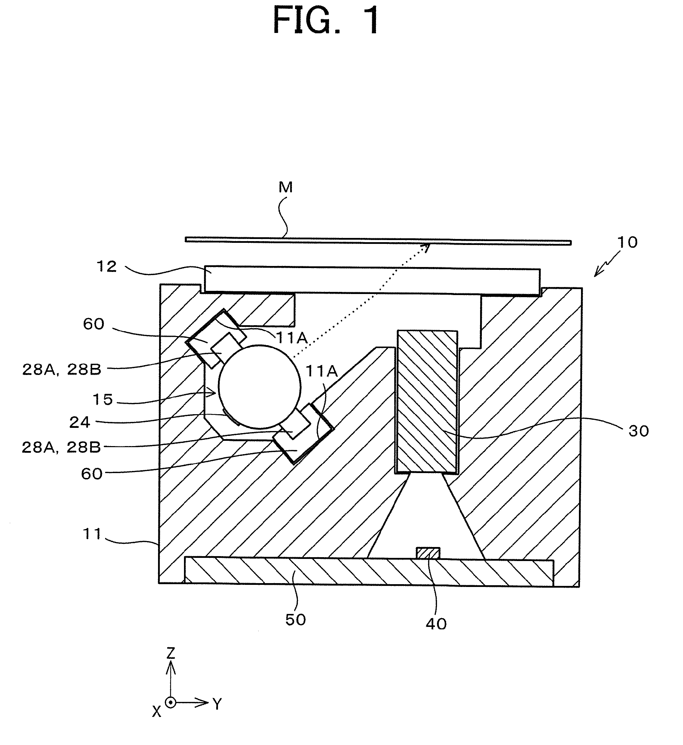

Now, Embodiment 1 of the present disclosure will be described. FIG. 1 shows a contact image sensor 10 of the embodiment including a frame 11, a transparent body 12, an illuminating device 15, a rod lens array 30, a sensor IC 40, and a sensor board 50.

The frame 11 (a compartment) is a housing that supports the transparent body 12 and also accommodates the rod lens array 30, the sensor IC 40, and the sensor board 50.

The transparent body 12 serves as a document positioning plate for a document M, and is made of transparent plate-like member made of plastics or glass and other such component, allowing the light to pass through.

The illuminating device 15 emits a light via a light emitter on the light guide, which will be discussed later, against the transparent body 12 as presented by a dashed arrow in FIG. 1. The light is emitted across in a direction of a reading width of the document M, that is, the primary scan direction along the X axis direction shown in FIG. 1.

The rod lens array 30 includes lenses that converge the light reflected off of the document M.

The sensor IC 40 is formed by a light receiving element that performs a photoreception of the light converged on the rod lens array 30, and also performs a photoelectric conversion. Multiple sensor ICs 40 are linearly arranged in the primary scan direction, namely, the X axis direction. The sensor board 50 is used for installing the sensor IC 40. The sensor board 50 further outputs an image signal to external components.

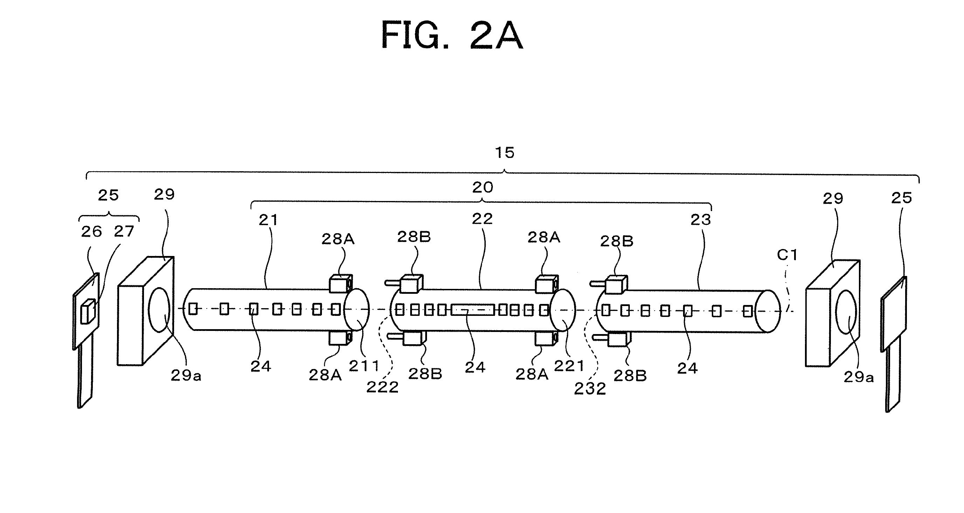

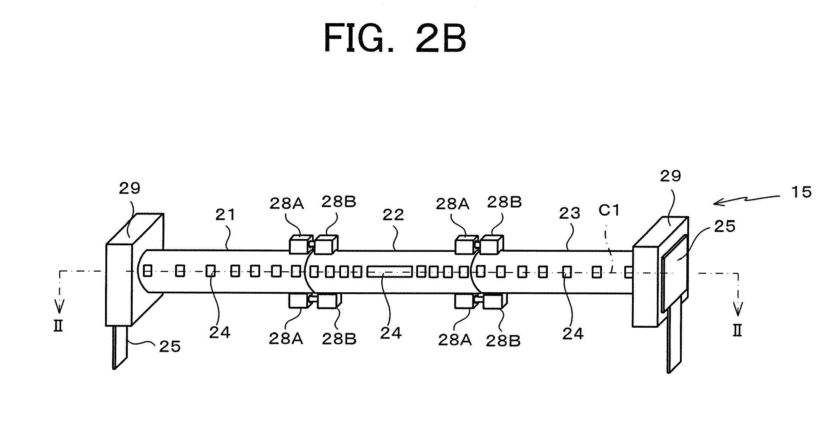

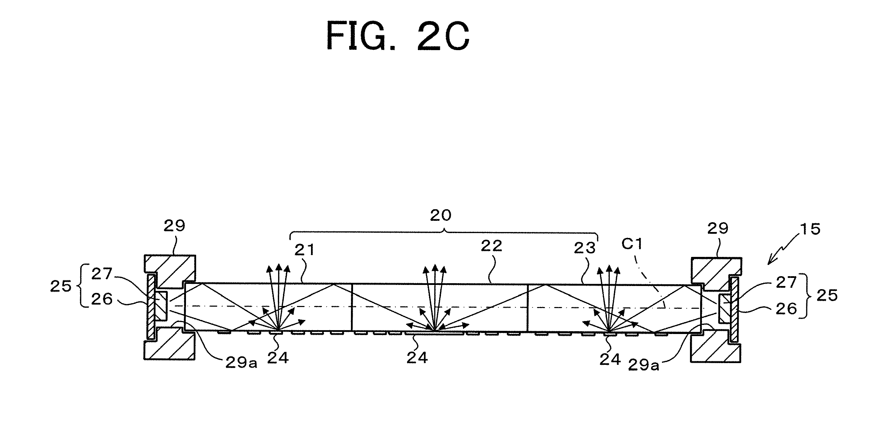

Here, structures of the illuminating device 15 are described with details. FIGS. 2A, 2B, and 2C show the illuminating device 15 including a light guide unit 20, a light-emitting diode unit 25, and a holder 29.

FIG. 2A shows the light guide unit 20 including a first light guide 21, a second light guide 22, and a third light guide 23. The first light guide 21, the second light guide 22, and the third light guide 23 are made of transparent resins such as acrylic and polycarbonate. The first light guide 21, the second light guide 22, and the third light guide 23 are all in the form of a cylinder having the same diameters.

The first light guide 21, the second light guide 22, and the third light guide 23 each has the central axis line C1 that coincides with one another, and the first light guide 21, the second light guide 22, and the third light guide 23 are arranged in series, as each of side surfaces thereof being flush with each other.

As shown in FIGS. 2A and 2B, the side surface of the first light guide 21, that of the second light guide 22, and that of the third light guide 23 included in the light guide unit 20 have pieces of a light scattering layer 24 formed within the light guide across the direction of the central axis line C1 of the light guide in the form of a row. The light scattering layer 24 is a coated film, for example, formed by a white ink and the like and is formed by coating the surface of the light guide.

Note that, as will be discussed later, the light emitted by the light-emitting diode unit 25 enters into the light guide unit 20 from the end portion thereof. The entering light decays the further the light is located from the end portion of the light guide unit 20. Thus, the pieces of the light scattering layer 24 are arranged for emission of the uniform outgoing light by the light emitter on the light guide unit 20.

To give an example, the pieces of the light scattering layer 24 may be arranged with spacing there between in the vicinity of the end portion on the light guide unit 20, while at around the center thereof, the pieces of the light scattering layer 24 may be arranged with narrower spacing. Further, the area of each piece of the light scattering layer 24 may be gradually increased from the end portion towards the center.

FIG. 2A shows the first light guide 21 including a pair of mating members 28A, 28A provided on the side surface in the vicinity of an end surface 211, that is abutted (close proximity) against the second light guide 22. The pair of mating members 28A, 28A is serving as means for alignment (a first alignment member). The pair of mating members 28A, 28A is fixed to the side surface of the first light guide 21 using adhesion and the like. The first mating members 28A, 28A are arranged in line symmetry about the central axis line C1.

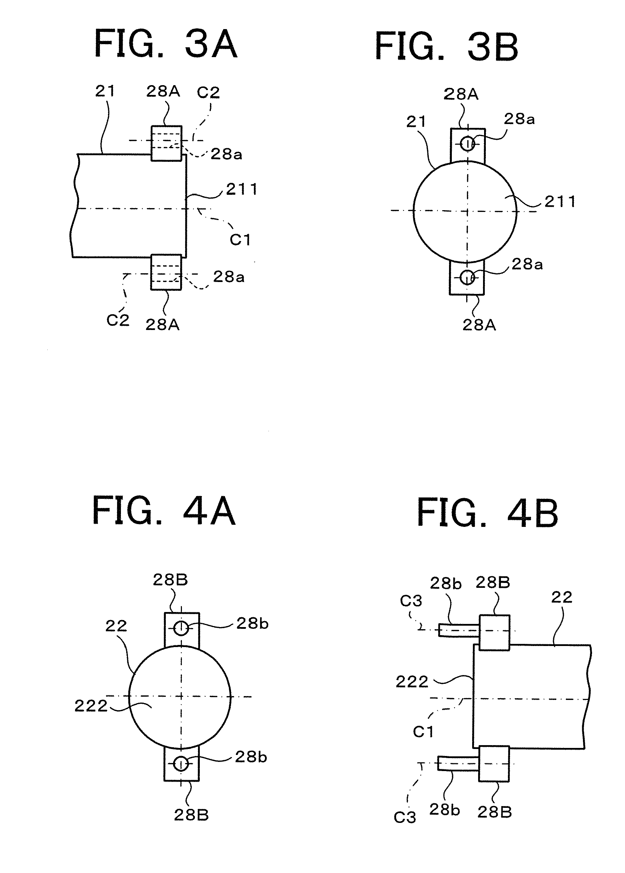

As shown in FIGS. 3A and 3B, the first mating member 28A is a substantially cuboid member having one surface thereof concaved to fit into the shape of side surfaces on the first light guide 21. The first mating member 28A has a circular through hole 28a. The through hole 28a is formed to have a central axis line C2 extend in the same direction as the central axis line C1.

Referring back to FIG. 2A, the second light guide 22 includes a pair of second mating members 28B, 28B provided on side surfaces in the vicinity of an end surface 222 that is abutted (close proximity) against the first light guide 21. The pair of second mating members 28B, 28B serves as means for alignment (a second alignment member). The pair of second mating members 28B, 28B is fixed to the side surface of the second light guide 22 using the adhesion and the like. The second mating members 28B, 28B are arranged in line symmetry about the central axis line C1.

As shown in FIGS. 4A and 4B, the second mating member 28B is a substantially cuboid member having one surface thereof concaved to fit into the shape of the side surface on the second light guide 22. The second mating member 28B has a cylindrical male portion 28b having a diameter substantially the same as that of the through hole 28a in the first light guide 21. Further, the male portion 28b is arranged to have its central axis C3 extend in the same direction with the central axis line C1 of the second light guide 22.

The distance between the central axis line C3 of the male portion 28b and the central axis line C1 of the second light guide 22 coincides with the distance between the central axis line C2 of the through hole 28a in the first mating member 28A of the first light guide 21 and the central axis line C1 of the first light guide 21.

FIG. 2A also shows the second light guide 22 further including a pair of first mating members 28A, 28A on the side surface in the vicinity of a surface 221 abutted (close proximity) against the third light guide 23.

The pair of first mating members 28A, 28A is fixed to the side surfaces on the second light guide 22 using the adhesion or the like. The first mating members 28A, 28A are arranged in line symmetry bout the central axis line C1.

The third light guide 23 also includes the pair of second mating members 28B, 28B on the side surface in the vicinity of an end surface 232 abutted (close proximity) against the second light guide 22.

The pair of second mating members 28B, 28B is fixed to the side surface of the third light guide 23 using the adhesion or the like. The second mating members 28B, 28B are arranged in line symmetry about the central axis line C1.

The pair of first mating members 28A, 28A provided on the second light guide 22 and the pair of second mating members 28B, 28B are respectively fixed to a location where, for example, a point at which the light scattering layer 24 on the side surface of the second light guide 22 is displaced by 90° about the origin, that is, the central axis line C1. The same arrangement applies to the pair of first mating members 28A, 28A provided on the first light guide 21, and the pair of second mating members 28B, 28B provided on the third light guide 23. With such structures, a light emission by each of the light guides is unhindered.

FIG. 2A shows the light-emitting diode unit 25 representing a light source that is implemented with a light-emitting diode 27 on the board 26.

FIGS. 2A and 2C show the holder 29 having a through hole 29a. The holder 29 provides support to the end portion of the light guide unit 20 with one opening of the through hole 29a. With such structures, the light emitted by the light-emitting diode 27 assuredly makes incidence on the end portion of the light guide unit 20. The holder 29 also provides support to the light-emitting diode unit 25 by the other opening of the through hole 29a.

The illuminating device 15 is constituted by the first light guide 21, the second light guide 22, the third light guide 23, the light-emitting diode unit 25, and the holder 29 each having the aforementioned structures, that are assembled as follows.

Firstly, the end surface 211 on the first light guide 21, or the end surface 222 on the second light guide 22 is coated with a transparent adhesion (not shown) such as a UV curable resin. Then, the through hole 28a of the first mating member 28A in the first light guide 21 is aligned with the male portion 28b of the second mating member 28B in the second light guide 22.

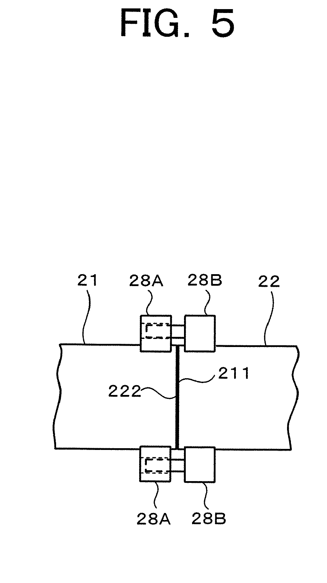

Further, the end surface 211 of the first light guide 21 and the end surface 222 of the second light guide 22 are drawn close against each other to insert the male portion 28b on the second mating member 28B into the through hole 28a in the first mating member 28A. Yet further, the end surface 211 of the first light guide 21 and the end surface 222 of the second light guide 22 are drawn close against each other to have both end surfaces abutted (close proximity) all along the outer peripheries thereof as presented in FIG. 5.

By this, the end surface 211 of the first light guide 21 and the end surface 222 of the second light guide 22 are connected together using the adhesion. This also allows the side surface of the first light guide 21 and the side surface of the second light guide 22 to be flush with each other.

Further, the second light guide 22 and the third light guide 23 are connected together by the same process used to connect the first light guide 21 with the second light guide 22 as described above.

A final process involves an insertion of the end portion on the first light guide 21 or the end portion on the third light guide 23 into the one opening on the holder 29, and an installment of the light-emitting diode unit 25 on the other opening of the holder 29.

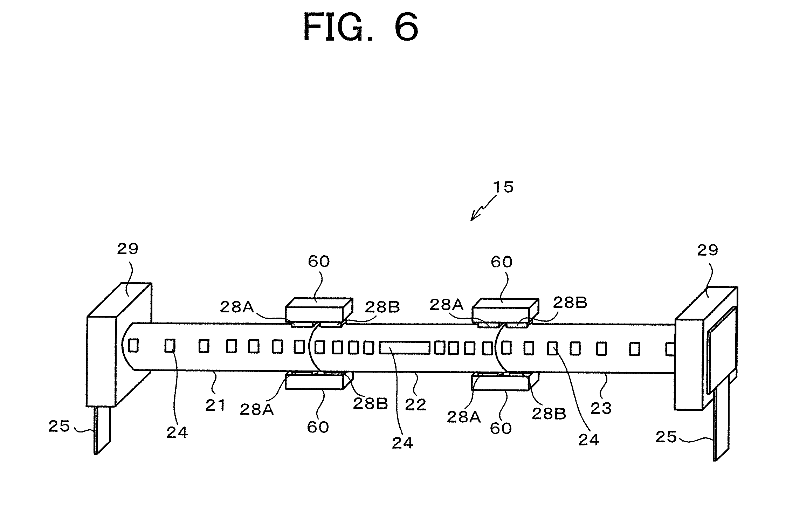

The illuminating device 15 assembled according to the embodiment includes spacers 60 that are provided for covering the first mating member 28A and the second mating member 28B as presented in FIGS. 1 and 6. The spacers 60 provide means for engaging the illuminating device 15 with the frame 11. The illuminating device 15 is installed on the frame 11 by having the spacers 60 engaged with an illuminating device installation section 11A formed on the frame 11 as presented in FIG. 1.

The image sensor 10 is assembled according to the descriptions above. Note that as seen in FIG. 1, when the illuminating device 15 is provided to the frame 11, the illuminating device 15 is arranged in such a way that the light guide unit 20 has the central axis line C1 thereof coincide with the primary scan direction along the X axis direction of FIG. 1. In the same way, the pieces of the light scatting layer 24 formed on the side surface of the light guide unit 20 are also arranged in a row with the primary scan direction along the X axis direction.

Here, an operation of the contact image sensor 10 having the aforementioned structures is described with details. The light-emitting diode 27 emits a light as soon as the electric power, not shown, for the contact image sensor 10 is turned ON. The emission of light enters into the light guide unit 20 and propagates within the light guide unit 20 in a longitudinal direction, that is, the central axis direction C1 of the light guide unit 20, as repeating a total reflection.

A portion of the propagating light within the light guide unit 20 reaches the light scattering layer 24 formed on the side surface of the light guide unit 20. The light reaching the light scattering layer 24 exhibits a diffuse reflection, and a portion of the light is emitted toward the outside by the light emitter that is located at a location where the light scattering layer 24 on the side surface of the light guide unit 20 is displaced by 180° about the origin, that is, the central axis line C1 (see FIG. 1, a dashed arrow; and FIG. 2C).

At this event, the pieces of the light scattering layer 24 formed on the side surface of the light guide unit 20 are provided in series with the X axis direction. As a result, the light emitter is formed on the side surface of the light guide unit 20 along the X axis direction and also in the shape of a straight line, with the light emitted from the scattering layer 24.

The light guide unit 20 then emits a light in the shape of straight line via the light emitter in a direction perpendicular to the X axis. The light emitted from the light emitter on the light guide unit 20 passes through the transparent body 12 and provides the straight lined and the uniform illumination on the document M in the primary scan direction along the X axis direction as presented by the dashed arrow in FIG. 1.

The light irradiated by the light guide unit 20 and reflected off the document M is converged on the rod lens array 30. The light converged on the rod lens array 30 is photoelectrically converted by the sensor IC 40 on the sensor board 50. The sensor board 50 outputs an image signal to external components.

As described, the first light guide 21, the second light guide 22, and the third light guide 23 included in the light guide unit 20 according to the embodiment of the present disclosure respectively include either one of or both the first mating member 28A and the second mating member 28B to serve means for alignment (the first alignment member, the second alignment member, and the third alignment member).

By allowing the mating member 28A to be fitted with the mating member 28B, the end surfaces can be easily abutted (close proximity) against each other to have matching outer profiles of the end surfaces in each light guide, which also allows the side surfaces having the light emitters on the each light guide to be flush with each other.

Further due to the pieces of the light scattering layer 24 on the light guide unit 20 being arranged in a row along the primary scan direction, the light guide unit 20 is able to provide the straight lined and uniform illumination along the primary scan direction on the document positioning surface.

Note that in this embodiment according to the present disclosure, the end surface on the third light guide 23 is abutted against the end surface of the second light guide 22, and the connection is made in the order of the first light guide 21, the second light guide 22, and the third light guide 23.

Though, such order of connection may be modified; connection may be made in the order of the third light guide 23, the first light guide 21, and the second light guide 22, after the end surface on the third light guide 23 is abutted against the end surface of the second light guide 22. Further, the side surface of the third light guide 23 and the side surface of the first light guide 21 are also flush with each other.

### Embodiment 2

Hereinafter, Embodiment 2 of the present disclosure is described.

The fundamental structure of the contact image sensor 10 is the same as that in Embodiment 1. Embodiment 2 employs the shape of the mating member on the light guide unit 20 that is different from that of Embodiment 1.

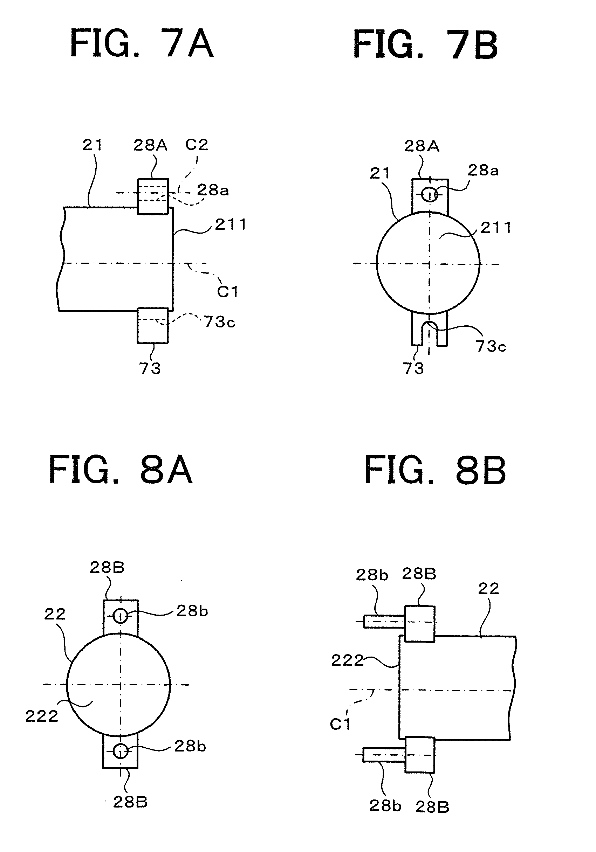

FIGS. 7A and 7B show the first light guide 21 including a first mating member 28A and a third mating member 73 on the side surface in the vicinity of the end surface 211 abutted (close proximity) against the second light guide 22. The first mating member 28A and the third mating member 73 are provided to serve means for alignment. The first mating member 28A and the third mating member 73 are fixed to the side surface of the first light guide 21 using the adhesion and the like. The first mating member 28A and the third mating member 73 are arranged in line symmetry about the central axis line C1.

FIGS. 7A and 7B present the first mating member 28A that is equivalent to that described in Embodiment 1.

As shown in FIGS. 7A and 7B the third mating member 73 is a substantially cuboid member having one surface thereof being concaved to fit into the shape of the side surface on the first light guide 21. The third mating member 73 also includes a groove 73c. Further, the groove 73c is formed in the radius direction of the first light guide 21 and also in the same direction with the central axis direction C1 of the first light guide 21 as shown in FIG. 7B.

FIGS. 8A and 8B show the second light guide 22 including the pair of second mating members 28B, 28B on the side surface in the vicinity of the end surface 222 that is abutted (close proximity) against the first light guide 21. The pair of second mating members 28B, 28B is provided to serve means for alignment.

The pair of the second mating members 28B, 28B is fixed to the side surface on the second light guide 22 using the adhesion and the like. Further, the pair of second mating members 28B, 28B is arranged in line symmetry about the central axis line C1. The second mating member 28B referred in this embodiment has the same feature described in Embodiment 1.

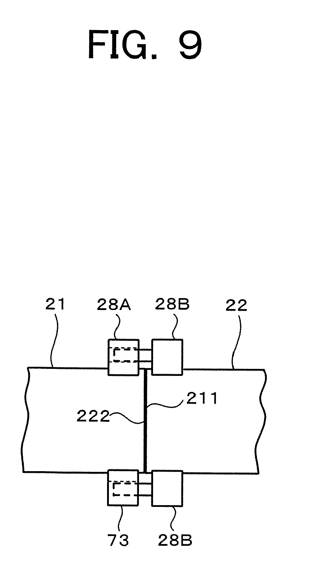

The first light guide 21 and the second light guide 22 having the aforementioned structures are connected together in the same manner described in Embodiment 1. As shown in FIG. 9, the groove 73c on the third mating member 73 and the male portion 28b on the second mating member 28B are fitted with each other while allowing for a backlash play in the radius direction of the first light guide 21 and the second light guide 22.

As described above, the light guide unit 20 according to this embodiment employs a hole in one of the mating members that is fitted in by the other mating member, and also employs a groove in the other mating member, whereby allowing the mating members to be fitted with each other regardless of dimension errors which may have occurred in the light guide and in the mating members.

### Embodiment 3

Hereinafter, Embodiment 3 according to the present disclosure is described.

The fundamental structure of the contact image sensor 10 being the same as that of Embodiment 1. Embodiment 3 differs from the aforementioned Embodiment 1 in that Embodiment 3 employs the mating members on the end portion of the light guide unit.

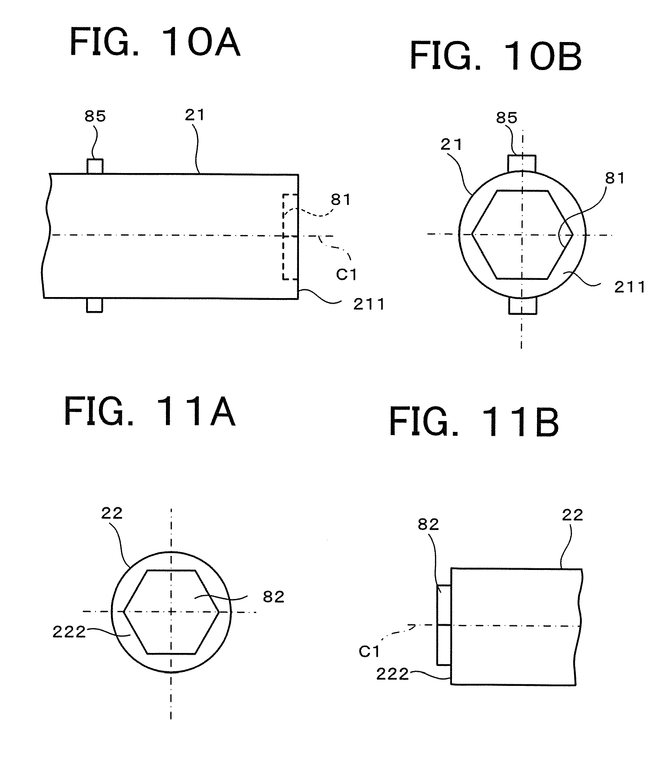

As shown in FIGS. 10A and 10B, the end surface 211 of the first light guide 21 that is abutted (close proximity) against the second light guide 22, has a concave portion 81 formed thereon. The concave portion 81 is provided to serve the means for alignment. The concave portion 81 employs a regular hexagon as viewed from the side surface relative to the central axis line C1.

FIGS. 11A and 11B show the end surface 222 on the second light guide 22 that is abutted (close proximity) against the first light guide 21, has a convex portion 82 formed thereon. The convex portion 82 is provided to serve the means for alignment. The convex portion 82 employs a regular hexagon as viewed from the side surface relative to the central axis line C1.

The convex portion 82 also employs the size approximately the same as that of the concave portion 81 on the first light guide 21 to have the convex portion 82 fitted with the concave portion 81.

The first light guide 21 and the second light guide 22 having the aforementioned structures are connected as follows. Firstly, the end surface 211 on the first light guide 21 or the end surface 222 on the second light guide 22 is coated with the transparent adhesion (not shown) such as the UV curable resin. Then, the alignment between the concave portion 81 on the first light guide 21 and the convex portion 82 on the second light guide 22 is made. Further, the end surface 211 of the first light guide 21 and the end surface 222 of the second light guide 22 are drawn close against each other to have the convex portion 82 inserted into the concave portion 81a.

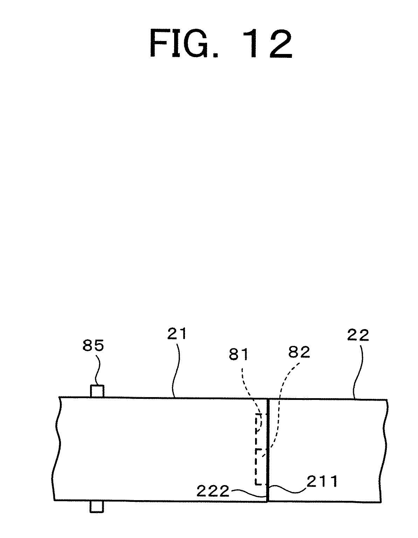

Yet further, the end surface 211 of the first light guide 21 and the end surface 222 of the second light guide 22 are drawn close against each other to have the both end surfaces abutted (close proximity) all along the outer peripheries of the both end surfaces, as presented in FIG. 12. With such structures, the end surface 211 of the first light guide 21 and the end surface 222 of the second light guide 22 are connected together using the adhesion.

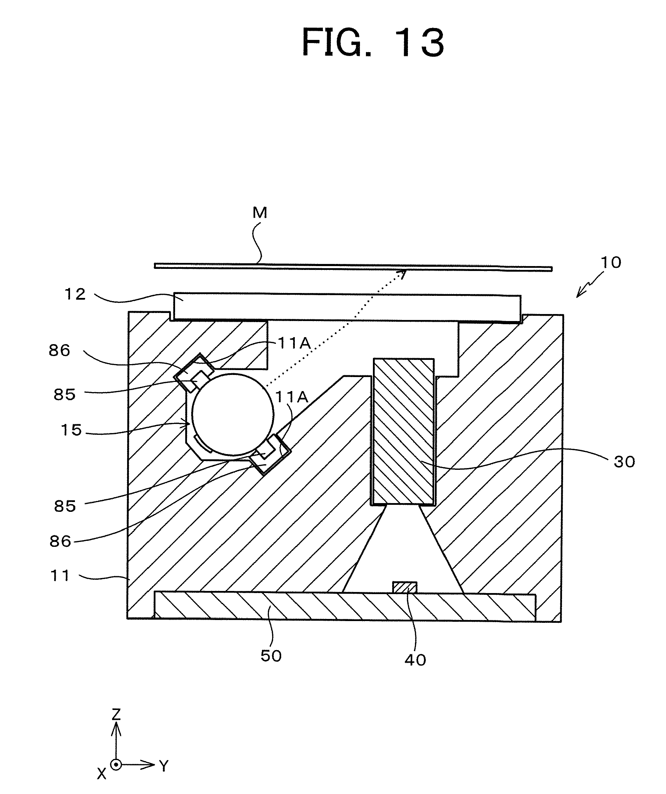

FIG. 10A shows the side surface of the first light guide 21 includes convex members 85 formed thereon. Further as shown in FIG. 13, the illuminating device 15 includes spacers arranged for covering the convex members 85. The spacers 86 are provided to serve as means for engagement to the frame 11. The illuminating device 15 is installed on the frame 11 by engaging the spacers 86 with the illuminating device installation section 11A formed on the frame 11 as shown in FIG. 13.

As described above, the light guide unit according to Embodiment 3 requires no engaging members on the side surface of the light guide as is required in the light guide unit according to Embodiment 1, thereby enabling the parts count reduction compared to the light guide unit according to Embodiment 1.

### Embodiment 4

Hereinafter, Embodiment 4 of the present disclosure is described.

The fundamental structure of the contact image sensor 10 being the same as that of Embodiment 1. Embodiment 4 differs from the aforementioned Embodiment 1 in that Embodiment 4 employs two light guides that constitute the light guide unit.

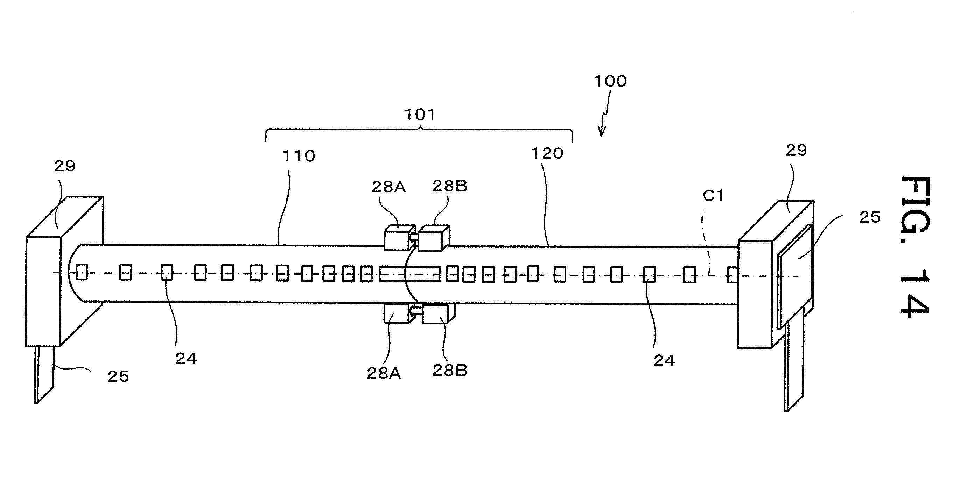

FIG. 14 shows the illuminating device 100 including a light guide unit 101, the light-emitting diode unit 25, and the holder 29.

The light guide unit 101 includes two light guides formed in the same way the light guide according to Embodiment 1 is formed. In particular, the light guide unit 101 includes a first light guide 110 and a second light guide 120. The first light guide 110 and the second light guide 120 each has the central axis line C1 that coincide with each other, and form the series arrangement such that the side surfaces are flush with each other. The first light guide 110 and the second light guide 120 are adjacent to each other, and also, each end surface on the first light guide 110 and the second light guide 120 is abutted (close proximity) against each other.

The first light guide 110 also includes the pair of first mating members 28A, 28A on the side surface in the vicinity of the end surface that is abutted (close proximity) against the second light guide 120, in the same way with the first light guide 21 in Embodiment 1.

As for the second light guide 120, which also includes the pair of second mating members 28B, 28B on the side surface in the vicinity of the end surface on the first light guide 110, in the same way with the second light guide 22 in Embodiment 1.

The first light guide 110 and the second light guide 120 are connected together according to the same process described in Embodiment 1.

As described above, the light guide unit according to Embodiment 4 may implement two light guides as the number of the light guide included is not limited to three.

### Embodiment 5

Hereinafter, Embodiment 5 of the present disclosure is described.

The fundamental structure of the contact image sensor 10 being the same as that of Embodiment 1. Embodiment 5 differs from the aforementioned Embodiment 1 in that Embodiment 5 employs n (where n is an integer equal to or greater than 3) light guides constituting the light guide unit.

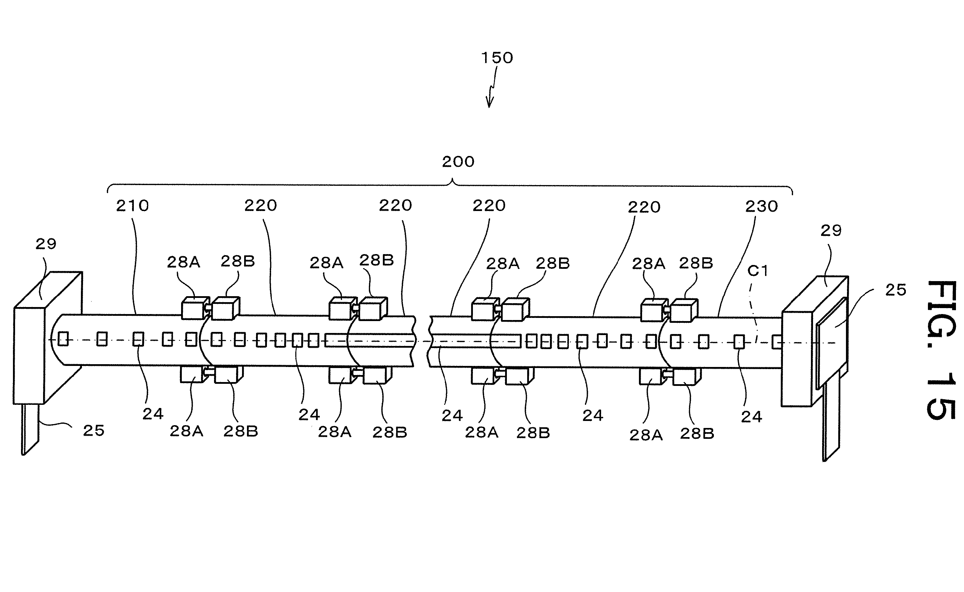

FIG. 15 shows the illuminating device 150 including a light guide unit 200, the light-emitting diode unit 25, and the holder 29.

The light guide unit 200 includes n (where n is an integer equal to or greater than 3) light guides that are formed by the same process used in forming the light guide according to Embodiment 1. The light guide unit 200 further includes the first light guide 210, the third light guide 230, and (n-2) second light guides 220 provided between the first light guide 210 and the third light guide 230 that are arranged in series.

The first light guide 210, the third light guide 230, and the second light guides 220 each has the central axis line C1 that coincides with one another, and each surface thereof is lined up to form a flush-surface. The first light guide 210, the third light guide 230, and the second light guide 220 are abutted (close proximity) with each other on the adjacent end surfaces of the light guides.

The first light guide 210 includes the pair of first mating members 28A, 28A on the side surface in the vicinity of the end surface that is abutted (close proximity) against the second light guide 220 as in the same manner for the first light guide 21 in Embodiment 1.

The second light guide 220 includes the pair of mating members 28B, 28B on the side surface in the vicinity of the end surface of the first light guide 210, as in the same manner for the second light guide 22 in Embodiment 1. The second light guide 220 also includes the pair of first mating members 28A, 28A on the side surface in the vicinity of the end surface on the third light guide 230.

The third light guide 230 includes the pair of second mating members 28B, 28B on the side surface in the vicinity of the end surface that is abutted (close proximity) against the second light guide 220, in the same manner for the third light guide 23 in Embodiment 1.

The first light guide 210, the second light guide 220, and the third light guide 230 are connected together according to the same process described in Embodiment 1.

As described, the light guide unit according to Embodiment 5 may employ equal to or greater than three light guides as the number of light guides included is not limited to three as though such limitation is applied to Embodiment 1.

The embodiments of the present disclosure has been described above, yet the present disclosure is not limited to the aforementioned embodiments but is intended to cover various modifications in addition to the applications. To give an example, the aforementioned embodiments have employed the cylinder-shaped light guide; however, the shapes of the end surface and the cross sections in the light guide are not particularly limited as such and thus, polygonal columns, e.g., a quadrangular prism may certainly be employed. Alternatively, a planar shape may also be employed by cutting across the side surface of the cylindrical light guide in a direction parallel to the central axis line C1 as shown in FIG. 15.

The aforementioned second light guides 22 and 220 according to the embodiments have been described to include two types of mating members, that is, the first mating member 28A that is provided in the vicinity of one of the end portions, and the second mating member 28B that is provided in the vicinity of the other end portion thereof, yet the present disclosure is not limited to such particular structure.

If the first mating member 28A is provided on one of the adjacent light guides and the second mating member 28B is provided on the other light guide, and these mating members are allowed to be fitted together, then the second light guides 22 and 220 may be employed with the same mating members in the vicinity of both ends.

While the present disclosure has been described in detail and with reference to specific embodiments thereof, it will be apparent to those skilled in the art that various changes and modifications can be made therein without departing from the spirit and scope thereof. It is understood that the aforementioned embodiments are for illustrative purposes only, and the present disclosure is not limited to the specific embodiments as illustrated herein, but is only presented by the following claims.

Further, it is intended that the present disclosure cover the modifications and variations of this present disclosure provided they come within the scope of the appended claims and their equivalents.

The present application is based on Japanese Patent Application No. 2012-035955 filed on February 22, 2012. The entire subject matter of Japanese Patent Application No. 2012-035955, including the specification, the claims, and the drawings thereof is incorporated herein by reference.

### Industrial Applicability

The present disclosure is suitable in optical instruments such as image scanners and the like.

### List of Reference Signs

- 10: Contact image sensor
- 11: Frame
- 12: Transparent body
- 15: Illuminating device
- 20: Light guide unit
- 21: First light guide
- 211: End surface
- 22: Second light guide
- 221: End surface
- 222: End surface
- 23: Third light guide
- 232: End surface
- 24: Light scattering layer
- 25: Light-emitting diode unit
- 26: Board
- 27: Light-emitting diode
- 28A: First mating member
- 28a: Through hole
- 28B: Second mating member
- 28b: Male portion
- 29: Holder
- 29a: Through hole
- 30: Rod lens array
- 40: Sensor IC
- 50: Sensor board
- 60: Spacer
- 73: Third mating member
- 73c: Groove
- 81: Concave portion
- 82: Convex portion
- 85: Convex member
- 86: Spacer
- 100: Illuminating device
- 101: Light guide unit
- 110: First light guide
- 120: Second light guide
- 150: Illuminating device
- 200: Light guide unit
- 210: First light guide
- 220: Second light guide
- 230: Third light guide

## Claims

1. A light guide unit comprising:
- a first light guide in a column shape that is adapted to take a light incident upon one end surface of the first light guide, and to emit the light from other end surface thereof and from a light emitter on a side surface thereof bridging between the one end surface and the other end surface;
- a second light guide in a column shape that is adapted to take the light emitted from the other end surface of the first light guide and incident upon one end surface of the second light guide, and to emit the light from the light emitter on a side surface thereof bridging between the one end surface and the other end surface of the second light guide, and the one end surface of the second light guide that is located close proximity to the other end surface of the first light guide;
- a first alignment member formed on the first light guide;
- a second alignment member formed on the second light guide, wherein the other end surface of the first light guide and the one end surface of the second light guide are located in close proximity to each other, and the side surface having the light emitter on the first light guide and the side surface having the light emitter on the second light guide are flush with each other, such that the first alignment member is engaged by the second alignment member.

2. The light guide unit according to Claim 1, wherein
the first alignment member is formed by a first engaging member arranged on the side surface of the first light guide, and the second alignment member is arranged on the side surface of the second light guide and the second alignment member is formed by a second engaging member that engages with the first engaging member.

3. The light guide unit according to Claim 2, wherein
the second engaging member includes a convex portion, and the first engaging member includes a through hole or a non-through hole having a matching shape to the convex portion formed on the second engaging member.

4. The light guide unit according to Claim 2, wherein
the second engaging member includes a convex portion, and the first engaging member includes a groove formed thereon that engages with the convex portion.

5. The light guide unit according to any one of Claims 1 to 4, wherein
a plurality of first alignment members is arranged on the first light guide, and a matching number of second alignment members is arranged on the second light guide, wherein the matching number corresponds to number of the plurality of first alignment members arranged.

6. The light guide unit according to Claim 1, wherein
the second alignment member is formed by a convex portion that is formed on the end surface of the second light guide, and the first alignment member is formed by a convex portion with a matching size and shape to the convex portion of the second light guide that is formed on the end surface of the first light guide.

7. The light guide unit according to any one of Claims 1 to 6, further comprising:
- a third light guide in a column shape that is adapted to take the light incident upon one end surface of the third light guide, and to emit the light from other end surface thereof and from the light emitter on a side surface thereof bridging between the one end surface and the other end surface, and the other end surface of the third light guide that is located close proximity to an outer profile of the one end surface of the first light guide, or to the other end surface of the second light guide;
- a third alignment member formed on the first light guide or the second light guide; and
- a fourth alignment member formed on the third light guide, wherein the other end surface on the third light guide is located close proximity to the one end surface of the first light guide or to the other end surface of the second light guide, and the side surface having the light emitter on the third light guide and the side surface having the light emitter on the first light guide or the side surface having the light emitter on the second light guide are flush with each other, such that the third alignment member is engaged with the fourth alignment member.

8. A light guide unit comprising:
- a plurality of light guides each having a column shape that is adapted to take a light incident upon each one end surface of the plurality of light guides, and to emit the light from each respective other end surface and from each light emitter on each respective side surface of the plurality of light guides bridging between the each one end surface and the each respective other end surface, and that the each one end surface of the plurality of light guides and the each respective other end surface thereof are located close proximity, and end surfaces are adjacently arranged by abutted against each other;
- a first alignment member formed on one of adjacent light guides; and
- a second alignment member formed on the other of the adjacent light guides, wherein end surfaces on the adjacent light guides are located close proximity to each other, and the second alignment member is engaged with the first alignment member while side surfaces each having the light emitter on the adjacent light guides are flush with each other.

9. The light guide unit according to Claim 8, wherein
the first alignment member is formed by a first engaging member arranged on one side surface of the adjacent light guides, and the second alignment member is arranged on other side surface of the adjacent light guides and is formed by a second engaging member that engages with the first engaging member.

10. The light guide unit according to Claim 9, wherein
the second engaging member includes a convex portion, and the first engaging member includes a through hole or a non-through hole formed thereon having a matching shape to the convex portion.

11. The light guide unit according to Claim 9, wherein
the second engaging member includes a convex portion, and the first engaging member includes a groove formed thereon that matches the convex portion.

12. The light guide unit according to any one of Claims 8 to 11, wherein
a plurality of first alignment members is arranged on one of the adjacent light guides, and a matching number of second alignment members is arranged on the end surface of other light guide of the adjacent light guides, wherein the matching number corresponds to number of the plurality of first alignment members arranged.

13. The light guide unit according to Claim 8, wherein
the second alignment member is formed by a convex portion formed on the end surface on one of the adjacent light guides, wherein the end surface is abutted against the other light guide, and the first alignment member is formed by a concave portion having a size and a shape that match the convex portion formed on the end surface on the other of the adjacent light guides, wherein the end surface is abutted against the one of the light guides.

14. An image sensor comprising
the light guide unit according to any one of Claims 1 to 7.

15. The image sensor according to Claim 14, further comprising
- a compartment that accommodates the light guide unit, wherein
- the compartment is adapted to accommodate the light guide unit by supporting the first alignment member and the second alignment member.

16. The image sensor according to Claim 14 or Claim 15, further comprising
- a plurality of sensors that is linearly arranged, wherein
- pieces of a light scattering layer are formed on the first alignment member and on the side surface of the second light guide that scatters an incident light, and
- the pieces of the light scattering layer are formed in a row, in a same direction the plurality of sensors is arranged.

17. An image sensor comprising
the light guide unit according to any one of Claims 8 to 13.

18. The image sensor according to Claim 17, further comprising a compartment that accommodates the light guide unit, wherein
the compartment is adapted to accommodate the light guide unit by supporting the first alignment member and the second alignment member.

19. The image sensor according to Claim 17 or Claim 18, further comprising
- a plurality of sensors that is linearly arranged, wherein
- pieces of a light scattering layer are formed on the side surface of the light guide that scatters an incident light, and
- the pieces of the light scattering layer are formed in a row, in a same direction the plurality of sensors is arranged.
